# EUROPEAN PATENT APPLICATION

(11) **EP 4 203 017 A1**
(43) Date of publication of application: **28.06.2023**
(21) Application number: 21858146.0
(22) Date of filing: 30.07.2021
(51) Int. Cl.: H01L 23/473, H05K 7/20, H01S 5/024

(54) **LASER MODULE**

(30) Priority: 19.08.2020 JP 2020138549
(71) Applicant: Panasonic Intellectual Property Management Co., Ltd., Osaka-shi, Osaka 540-6207 (JP)
(72) Inventor: OOMORI, Kouji, Osaka-shi, Osaka 540-6207 (JP); TADA, Masahiro, Osaka-shi, Osaka 540-6207 (JP); UCHIDA, Takafumi, Osaka-shi, Osaka 540-6207 (JP); IWASAWA, Ayako, Osaka-shi, Osaka 540-6207 (JP); MURAO, Fumiya, Osaka-shi, Osaka 540-6207 (JP)
(74) Representative: Novagraaf International SA
(86) International application number: PCT/JP2021/028263
(87) International publication number: WO 2022/038998

(57) **Abstract**

First block (10) includes internal flow path (15). A cooling medium flows inside internal flow path (15). Curved part (56) is provided at a corner between bottom surface (54) and side wall surface (55) of internal flow path (15). Curved part (56) is continuously connected to bottom surface (54) and side wall surface (55) of internal flow path (15) and has a curved shape.

## Description

### TECHNICAL FIELD

The present disclosure relates to a laser module.

### BACKGROUND ART

Conventionally, a water-cooled radiator used for cooling a heating element such as a laser element is known (see, e.g., PTL 1).

PTL 1 discloses a configuration in which an upper heat radiation plate, an intermediate heat radiation plate, and a lower heat radiation plate are laminated in three layers, and cooling water flows in a folded water passage formed between a water inlet and a water outlet in a communication hole of the intermediate heat radiation plate to cool a heat receiving end of the intermediate heat radiation plate.

Here, the heat radiation plate is made of a metal material having excellent heat conduction, for example, copper (Cu). In addition, plating layers are provided on the surface of the base material in order to enhance corrosion resistance of the heat radiation plate.

### Citation List

### Patent Literature

PTL 1: Unexamined Japanese Patent Publication No. 2005-294769

### SUMMARY OF THE INVENTION

### Technical problems

However, in a configuration in which a water passage is formed in a heat radiation plate as in a conventional water-cooled radiator, a crack may be generated in plating layers provided in a base material, water may penetrate from the crack, ionization of copper may be facilitated by application of a current, and the base material may corrode.

Specifically, in the process of plating the heat radiation plate, the plating layer growing in the direction orthogonal to the bottom surface of the water passage and the plating layer growing in the direction orthogonal to the side wall surface of the water passage overlap each other at a corner between the bottom surface and the side wall surface of the water passage, and grain boundaries are generated in the plating layers. As a result, a crack is likely to be generated in the plating layers at the corner between the bottom surface and the side wall surface of the water passage.

In addition, when heat generated at the laser element is transferred to the heat radiation plate and thermal stress is applied to the heat radiation plate, the stress is concentrated toward the corner between the bottom surface and the side wall surface of the water passage, and a crack is likely to be generated in the plating layers.

The present disclosure has been made in view of such a point, and an object of the disclosure is to suppress corrosion of a block for cooling a laser element.

### Solutions to problems

A first aspect of the present invention is a laser module including: a laser element configured to emit laser light; a first block including a mounting surface, the laser element being placed on the mounting surface; a second block stacked on a stacking surface of the first block, the stacking surface being opposite to the mounting surface of the first block, in which the first block includes a recess, the recess being a part of the stacking surface and allowing a cooling medium to flow inside the recess, the recess includes a bottom surface, a side wall surface, and a curved part at a corner between the bottom surface and the side wall surface of the recess, and the curved part is continuously connected to the bottom surface and the side wall surface and has a curved shape.

According to the first aspect of the present invention, the recess is provided in the first block. A cooling medium to flow inside the recess. A curved part is provided at a corner between the bottom surface and the side wall surface of the recess. The curved part is continuously connected to the bottom surface and the side wall surface of the recess and has a curved shape.

With such a configuration, corrosion of the first block for cooling the laser element can be suppressed.

Specifically, the base material of the first block is provided with plating layers for enhancing corrosion resistance. Here, when the corner between the bottom surface and the side wall surface of the recess is formed at a right angle, grain boundaries are generated in the plating layers at the corner between the bottom surface and the side wall surface of the recess in the process of plating the first block, and a crack is likely to be generated in the plating layers.

On the other hand, in the present disclosure, the corner between the bottom surface and the side wall surface of the recess is formed in a curved shape. Thus, the plating layers growing in respective directions orthogonal to the bottom surface, the curved surface, and the side wall surface of the recess are continuously connected to each other, and grain boundaries are less likely to be generated in the plating layers.

In addition, when heat generated at the laser element is transferred to the first block and thermal stress is applied to the first block, the stress toward the corner between the bottom surface and the side wall surface of the recess is dispersed at the curved part. As a result, a crack is less likely to be generated in the plating layers provided at the corner of the recess, and corrosion of the first block can be suppressed.

In a second aspect of the present invention according to the first aspect of the present invention, the first block includes: a base material including a first metal; an alloy layer including an alloy containing the first metal and a second metal different from the first metal, the alloy layer provided on a surface of the base material; and a first plating layer including the second metal and provided on a surface of the alloy layer.

In the second aspect of the present invention, the first block includes a base material, an alloy layer provided on a surface of the base material, and a first plating layer provided on a surface of the alloy layer. The base material is made of a first metal. The first plating layer is made of a second metal. The alloy layer is made of an alloy containing the first metal and the second metal. For example, when the base material is made of copper (Cu) and the first plating layer is made of nickel (Ni), the alloy layer is made of an alloy of copper and nickel.

By providing the alloy layer between the base material and the first plating layer in this manner, the adhesion of the first plating layer is improved. Additionally, the alloy layer is formed by, for example, performing sinter treatment. Therefore, even when there is a flaw on the surface of the base material, the flaw is filled and planarized when the alloy layer is formed. As a result, the growth characteristics of the first plating layer becomes excellent, and generation of a crack can be suppressed.

In a third aspect of the present invention according to the second aspect of the present invention, the first plating layer is provided with, on a surface of the first plating layer, a second plating layer having corrosion resistance higher than corrosion resistance of the first plating layer.

In the third aspect of the present invention, the second plating layer is provided on the surface of the first plating layer. The second plating layer is made of metal having corrosion resistance higher than that of the first plating layer. For example, when the first plating layer is made of nickel (Ni), the second plating layer only needs to be made of gold (Au).

In this manner, corrosion resistance of the first block can be improved, and corrosion of the first block can be suppressed.

In a fourth aspect of the present invention according to any one of the first to third aspects of the present invention, the first block includes a plurality of fins each standing upright from the bottom surface of the recess and disposed spaced from each other in the recess, the first block includes a curved part at a corner between the bottom surface of the recess and each of the plurality of fins, and the curved part is continuously connected to the bottom surface and each of the plurality of fins and has a curved shape.

In the fourth aspect of the present invention, the first block includes a plurality of fins each standing upright from the bottom surface of the recess.

A curved part is provided at a corner between the bottom surface of the recess and the fin. The curved part is continuously connected to the bottom surface of the recess and the fin and has a curved shape.

As described above, by providing the plurality of fins in the first block to increase the heat dissipation area, heat generated at the laser element can be efficiently dissipated from the plurality of fins.

Furthermore, the corner between the bottom surface of the recess and the fin is formed in a curved shape. Thus, the plating layers growing in respective directions orthogonal to the bottom surface of the recess, the curved surface, and the side wall surface of the fin are continuously connected to each other, and grain boundaries are less likely to be generated in the plating layers.

In addition, when heat generated at the laser element is transferred to the first block and thermal stress is applied to the first block, the stress toward the corner between the bottom surface of the recess and the side wall surface of the fin is dispersed at the curved part. As a result, a crack is less likely to be generated in the plating layers provided at the corner of the recess, and corrosion of the first block can be suppressed. Advantageous effect of invention

According to the present disclosure, corrosion of the block for cooling the laser element can be suppressed.

### BRIEF DESCRIPTION OF THE DRAWINGS

Fig. 1 is a perspective view illustrating a configuration of a laser module according to an exemplary embodiment.
Fig. 2 is an exploded perspective view illustrating the configuration of the laser module.
Fig. 3 is a perspective view illustrating a configuration of a first block on an stacking surface side.
Fig. 4 is a view when the first block is viewed from the stacking surface side.
Fig. 5 is a front cross-sectional view illustrating a configuration of a curved part and plating layers of the first block in a partially enlarged manner.
Fig. 6 is a plan cross-sectional view illustrating the configuration of the laser module.
Fig. 7 is a front cross-sectional view illustrating the configuration of the laser module.
Fig. 8 is a side cross-sectional view illustrating the configuration of the laser module.

### DESCRIPTION OF EMBODIMENT

Hereinafter, exemplary embodiments of the present disclosure will be described with reference to the drawings. The following description of preferable exemplary embodiments is merely illustrative in nature, and is not intended to limit the present disclosure, its application, or its use.

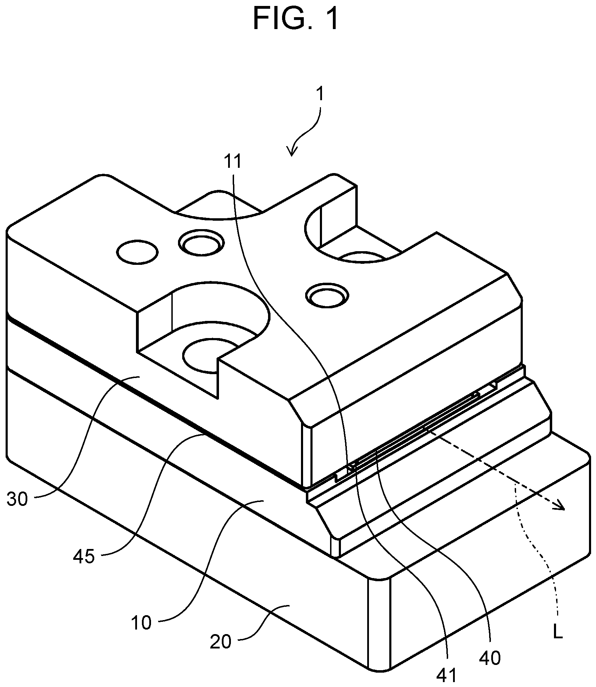

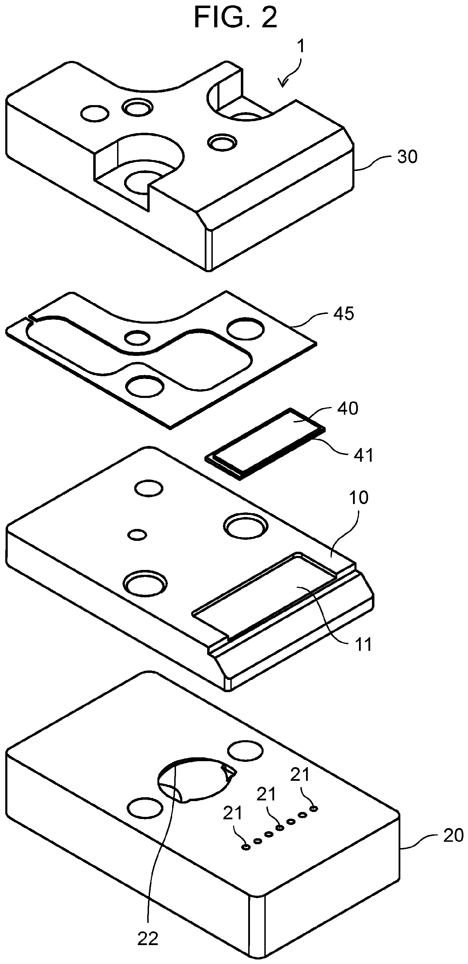

As illustrated in Figs. 1 and 2, laser module 1 includes first block 10, second block 20, third block 30, laser element 40, and insulating layer 45.

First block 10 has conductivity. As will be described in detail later, first block 10 is mainly made of copper (Cu). In first block 10, nickel (Ni) and gold (Au) are sequentially plated on a block made of copper.

First block 10 includes mounting surface 11. Mounting surface 11 is formed by recessing a part of an upper surface of first block 10. Mounting surface 11 is provided at an end, in an emission direction of laser light L (a direction indicated by an arrow line in Fig. 1), of the upper surface of first block 10.

Laser element 40 is mounted on mounting surface 11 via conductive sub-mount 41. Sub-mount 41 is mainly made of a copper-tungsten alloy (CuW).

Laser element 40 includes a lower surface as a positive electrode and an upper surface as a negative electrode. In laser element 40, when a current flows from the positive electrode toward the negative electrode, laser light L is output from a light emission surface.

The light emission surface of laser element 40 substantially coincides with a front end of mounting surface 11 of first block 10. The positive electrode of laser element 40 is electrically connected to first block 10. First block 10 has a function as an electrode block electrically connected to the positive electrode of laser element 40.

Insulating layer 45 is provided on the upper surface of first block 10. Insulating layer 45 is made of polyimide, ceramic, or the like.

Second block 20 is overlapped on a side opposite to mounting surface 11 of first block 10. Second block 20 is mainly made of stainless steel (SUS). In second block 20, nickel (Ni) and gold (Au) are sequentially plated on a block made of stainless steel.

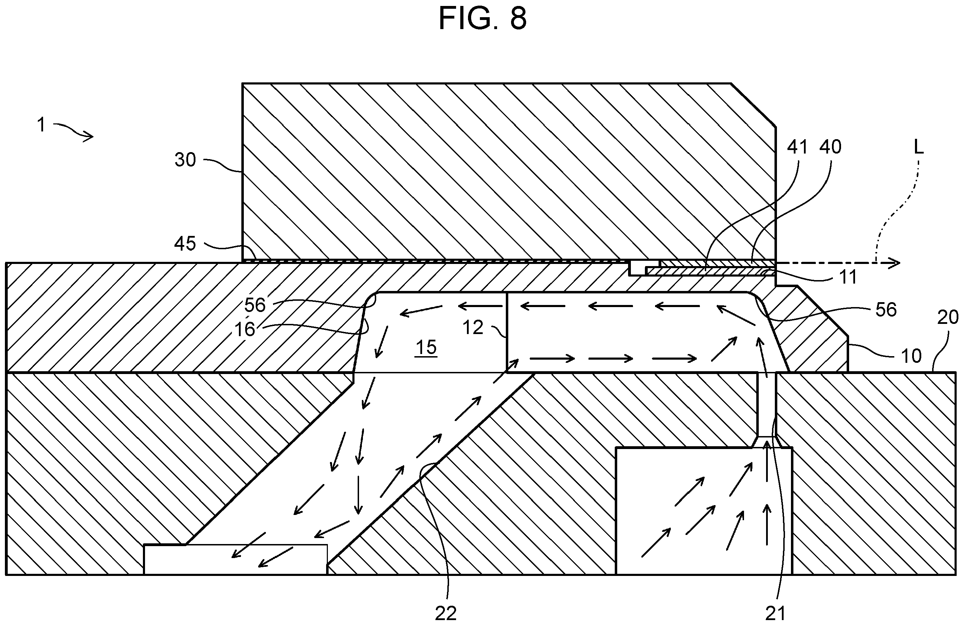

As will be described in detail later, internal flow path 15 through which a cooling medium to flow is provided between first block 10 and second block 20 (see Fig. 8).

Third block 30 has conductivity. Third block 30 is mainly made of copper (Cu). In third block 30, nickel (Ni) and gold (Au) are sequentially plated on a block made of copper.

Third block 30 is provided on laser element 40 and insulating layer 45. Third block 30 is electrically connected to laser element 40 via a bump (not illustrated). Third block 30 has a function as an electrode block electrically connected to the negative electrode of laser element 40.

First block 10, second block 20, and third block 30 are fastened by screws (not illustrated). At this time, third block 30 is fastened to first block 10 and second block 20 in an electrically insulated state.

In thus configured laser module 1, when a current flows from the positive electrode to the negative electrode of laser element 40, laser light L is output from the light emission surface on the side of laser element 40. At this time, heat generated in laser element 40 is transmitted to first block 10, second block 20, and third block 30.

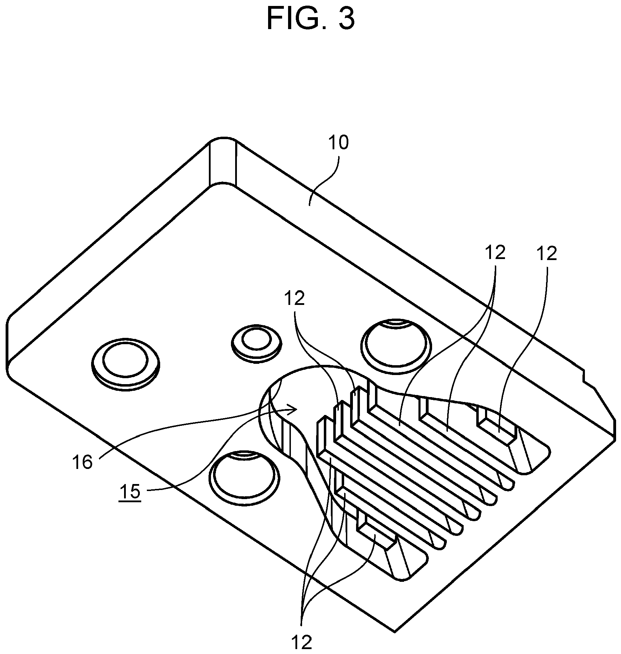

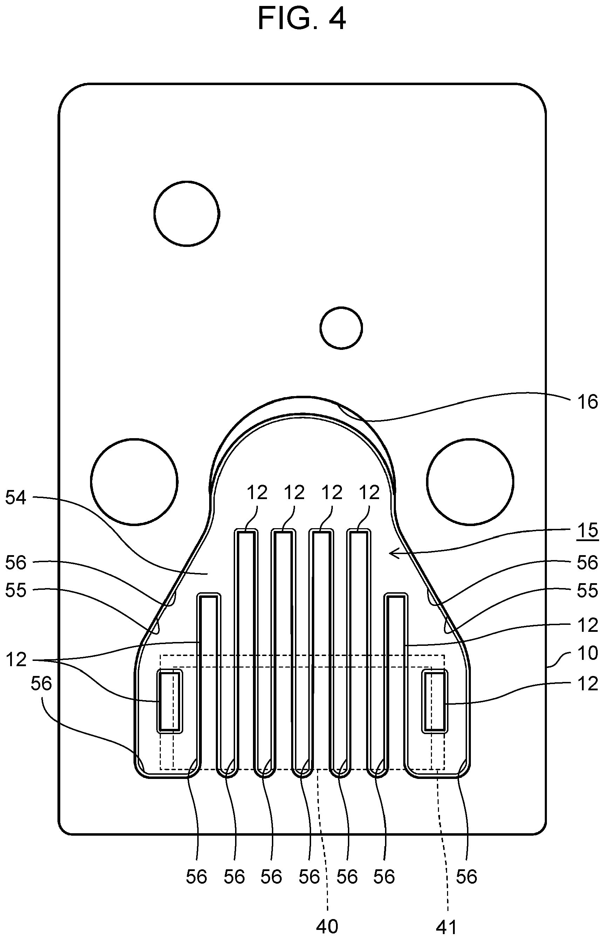

As illustrated in Figs. 3 and 4, first block 10 is provided with internal flow path 15 (recess). Internal flow path 15 is formed by recessing a part of a lower surface of first block 10. Internal flow path 15 extends rearward (leftward in Fig. 8) from a surface on a side opposite to mounting surface 11.

First block 10 is provided with a plurality of fins 12. Fins 12 each stand upright from the surface on the side opposite to mounting surface 11 of first block 10. Fins 12 are formed in a plate shape and extend along the emission direction of laser light L. The plurality of fins 12 are disposed spaced from each other in internal flow path 15 in a thickness direction.

In this manner, by providing the plurality of fins 12 in first block 10, a heat dissipation area of first block 10 is increased.

Incidentally, plating layers for enhancing corrosion resistance are provided on the surface of the base material of first block 10. Here, when a corner between the bottom surface and the side wall surface of internal flow path 15 or a corner between the bottom surface of internal flow path 15 and the side surface of fin 12 is formed at a right angle, a crack may be generated in the plating layers, and water may penetrate from the crack, so that the base material may corrode.

Therefore, laser module 1 according to the present exemplary embodiment has a structure in which a crack is less likely to be generated in the plating layers of first block 10 and corrosion of the first block is suppressed.

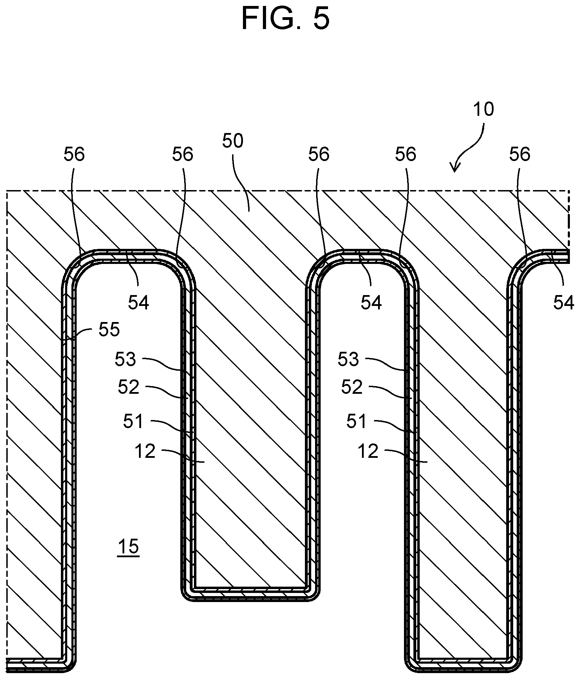

Specifically, as illustrated in Fig. 5, first block 10 includes base material 50, alloy layer 51, first plating layer 52, and second plating layer 53. Alloy layer 51 is provided on the surface of base material 50. First plating layer 52 is provided on the surface of alloy layer 51. Second plating layer 53 is provided on the surface of first plating layer 52.

Base material 50 is made of a first metal. The first metal is, for example, copper (Cu). Curved part 56 is provided at a corner between bottom surface 54 and side wall surface 55 of internal flow path 15 in base material 50. Curved part 56 is continuously connected to bottom surface 54 and side wall surface 55 of internal flow path 15 and has a curved shape.

Similarly, curved part 56 is provided at a corner between bottom surface 54 of internal flow path 15 and the side surface of fin 12 in base material 50. Curved part 56 is continuously connected to bottom surface 54 of internal flow path 15 and the side surface of fin 12 and has a curved shape.

Curved part 56 is formed by processing a corner of internal flow path 15 to be in a round shape having a radius within a range from about 0.1 mm to about 3.0 mm inclusive, for example.

Alloy layer 51 is provided on the surface of base material 50. Alloy layer 51 is made of an alloy containing the first metal and the second metal different from the first metal. In the present exemplary embodiment, the first metal is copper (Cu), and the second metal is nickel (Ni).

Alloy layer 51 is formed by plating base material 50 with nickel as the second metal and then performing sinter treatment at a temperature within a range, for example, from 700°C to 900°C inclusive, preferably at 800°C.

The thickness of alloy layer 51 is set within a range, for example, from 1 µm to 3 µm inclusive, preferably to 2 µm. Therefore, the thickness of the plating layer before the sinter treatment is preferably set to about 4 µm. With this configuration, even when there is a flaw on the surface of base material 50, the flaw is filled and planarized when alloy layer 51 is formed.

First plating layer 52 is provided on the surface of alloy layer 51. First plating layer 52 is made of nickel as the second metal. The thickness of first plating layer 52 is set within a range, for example, from 3 µm to 6 µm inclusive, preferably to 3.5 µm. With this configuration, generation of pinholes in first plating layer 52 can be suppressed.

In addition, first plating layer 52 is formed on the surface of alloy layer 51 containing nickel. Thus, the growth characteristics of first plating layer 52 becomes excellent, and the adhesion of first plating layer 52 is improved.

Second plating layer 53 is provided on the surface of first plating layer 52. Second plating layer 53 is made of metal having corrosion resistance higher than that of first plating layer 52. For example, when first plating layer 52 is made of nickel, second plating layer 53 is made of gold (Au).

The thickness of second plating layer 53 is set within a range, for example, from 0.1 µm to 1.0 µm inclusive, preferably to 0.3 µm. In this manner, corrosion resistance of first block 10 can be improved, and corrosion of first block 10 can be suppressed.

By providing curved part 56 at the corner between bottom surface 54 and side wall surface 55 of internal flow path 15 as described above, the plating layers growing in respective directions orthogonal to bottom surface 54, curved part 56, and side wall surface 55 of internal flow path 15 are continuously connected to each other in the process of plating treatment. As a result, grain boundaries are less likely to be generated in the plating layers. The same applies to the corner between bottom surface 54 of internal flow path 15 and the side surface of fin 12.

In addition, when heat generated at laser element 40 is transferred to first block 10 and thermal stress is applied to first block 10, the stress toward the corner of internal flow path 15 is dispersed at curved part 56.

As a result, a crack is less likely to be generated in alloy layer 51, first plating layer 52, and second plating layer 53 provided at the corner of internal flow path 15. Further, corrosion of first block 10 due to the cooling medium flowing through internal flow path 15 can be suppressed.

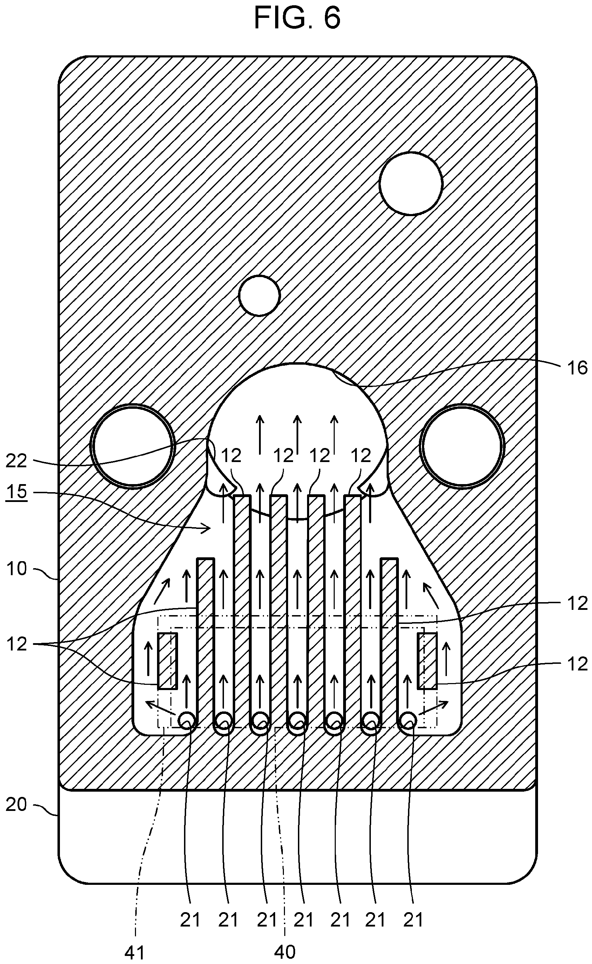

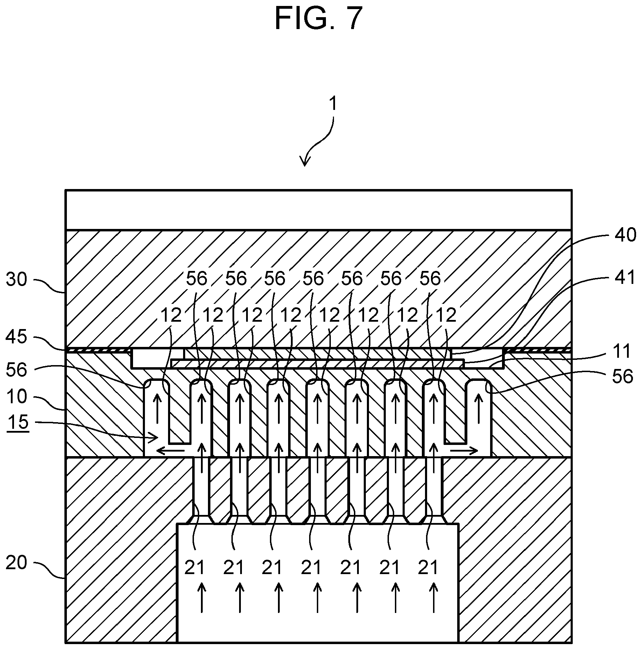

As illustrated in Figs. 6 to 8, second block 20 is overlapped on the side opposite to mounting surface 11 of first block 10. Internal flow path 15 is provided between first block 10 and second block 20.

Second block 20 includes a plurality of supply holes 21 and discharge hole 22. The plurality of supply holes 21 are open between the plurality of fins 12 when viewed from an stacking direction of first block 10 and second block 20. A cooling medium is supplied from the outside to supply hole 21 by a chiller unit (not illustrated). The cooling medium is, for example, water. Supply holes 21 supply the cooling medium to internal flow path 15. In Figs. 6 to 8, the flow of the cooling medium is indicated by arrow lines.

The cooling medium supplied from the plurality of supply holes 21 to internal flow path 15 is supplied between the plurality of fins 12 and flows toward a downstream side along an upper surface of internal flow path 15.

Discharge hole 22 is open on the downstream side of internal flow path 15 in second block 20. Discharge hole 22 discharges the cooling medium from internal flow path 15 to the outside to return the cooling medium to the chiller unit (not illustrated).

Discharge hole 22 extends in a direction inclined with respect to the stacking direction of first block 10 and second block 20. In the example illustrated in Fig. 8, discharge hole 22 is inclined obliquely downward toward the left side. Discharge hole 22 may be inclined by, for example, 45° with respect to the stacking direction.

First block 10 includes guide part 16. Guide part 16 guides the cooling medium flowing through internal flow path 15 toward an opening position of discharge hole 22. Guide part 16 is configured by a side wall on the downstream side of internal flow path 15. Guide part 16 extends in a direction forming an obtuse angle with respect to the surface on the side opposite to mounting surface 11. Guide part 16 may extend in a direction perpendicular to the surface on the side opposite to mounting surface 11.

This enables the cooling medium having flowed through internal flow path 15 and having collided with guide part 16 to be smoothly guided from guide part 16 toward discharge hole 22.

Here, discharge hole 22 is inclined with respect to the stacking direction. Thus, the cooling medium flowing toward discharge hole 22 collides with an inner peripheral surface of discharge hole 22 and then flows while being distributed to an upstream side and a downstream side of discharge hole 22 along the inclination direction of discharge hole 22. The inclination of discharge hole 22 is provided to generate such a flow of the cooling medium.

Meanwhile, a negative pressure is generated around supply hole 21 due to the flow during supplying the cooling medium from supply hole 21. Therefore, the cooling medium flowing toward the upstream side of discharge hole 22 passes between the plurality of fins 12, returns to an opening position of supply hole 21, and circulates through internal flow path 15.

The cooling medium supplied from supply hole 21 flows along the surface on the side opposite to mounting surface 11 of first block 10 to cool a base end side of fin 12. Meanwhile, the cooling medium returning from discharge hole 22 flows along an upper surface of second block 20 and cools a front end of fin 12.

As a result, by circulating the cooling medium along the entire surface of fins 12, heat generated at laser element 40 can be efficiently dissipated from the plurality of fins 12.

### INDUSTRIAL APPLICABILITY

As described above, since the present disclosure can provide a high practical effect that corrosion of a block for cooling a laser element can be suppressed, the present disclosure is extremely useful and has high industrial applicability.

### REFERENCE MARKS IN THE DRAWINGS

- 1: laser module
- 10: first block
- 11: mounting surface
- 12: fin
- 15: internal flow path (recess)
- 20: second block
- 40: laser element
- 50: base material
- 51: alloy layer
- 52: first plating layer
- 53: second plating layer
- 54: bottom surface
- 55: side wall surface
- 56: curved part
- L: laser light

## Claims

1. A laser module comprising:
a laser element configured to emit laser light;
a first block including a mounting surface, the laser element being placed on the mounting surface; and
a second block stacked on a stacking surface of the first block, the stacking surface being opposite to the mounting surface of the first block, wherein
the first block includes a recess, the recess being a part of the stacking surface and allowing a cooling medium to flow inside the recess, and
the recess includes a bottom surface, a side wall surface, and a curved part at a corner between the bottom surface and the side wall surface of the recess, and the curved part is continuously connected to the bottom surface and the side wall surface and has a curved shape.

2. The laser module according to Claim 1, wherein the first block includes
a base material including a first metal,
an alloy layer including an alloy containing the first metal and a second metal different from the first metal, the alloy layer provided on a surface of the base material, and
a first plating layer including the second metal and provided on a surface of the alloy layer.

3. The laser module according to Claim 2, wherein the first plating layer is provided with, on a surface of the first plating layer, a second plating layer having corrosion resistance higher than corrosion resistance of the first plating layer.

4. The laser module according to any one of Claims 1 to 3, wherein
the first block includes a plurality of fins each standing upright from the bottom surface of the recess and disposed spaced from each other in the recess, and
the first block includes a curved part at a corner between the bottom surface of the recess and each of the plurality of fins, and the curved part is continuously connected to the bottom surface and each of the plurality of fins and has a curved shape.
